# EUROPÄISCHE PATENTANMELDUNG

(11) **EP 4 539 636 A1**
(43) Veröffentlichungstag der Anmeldung: **16.04.2025**
(21) Anmeldenummer: 24198642.1
(22) Anmeldetag: 05.09.2024
(51) Int. Cl.: H10F 19/80, A01G 9/24, H10F 77/45

(54) **PHOTOVOLTAIKMODUL MIT KONVERSIONSLEUCHTSTOFF ZUR NUTZUNG IN AGRI-PHOTOVOLTAIK-ANLAGEN**

(30) Priorität: 12.10.2023 DE 102023127880
(71) Anmelder: SB Fine Chemicals Germany GmbH, 17489 Greifswald (DE)
(72) Erfinder: Tews, Stefan, 17489 Greifswald (DE); Sievert, Katharina, 18516 Süderholz (DE); Opolka, Andrea, 18516 Süderholz (DE)
(74) Vertreter: Engel, Christoph Klaus

(57) **Zusammenfassung**

Die Erfindung betrifft ein Photovoltaikmodul (01) mit mehreren bei Lichteinfall elektrische Energie erzeugenden Solarzellen (02). Die Solarzellen sind zwischen transparenten Trägerplatten (04) reihen- oder matrixförmig angeordnet, wobei zwischen jeweils benachbarten Solarzellen (02) transparente Abstandsbereiche (03) verbleiben, in denen sich die Solarzellen nicht erstrecken. Mindestens in einigen der Abstandsbereiche (03) sind anorganische Konversionsleuchtstoffe (06) angeordnet, welche Strahlung in einem Absorptionsbereich absorbieren, um dadurch angeregt Strahlung in mindestens einem Emissionsbereich zwischen 430 bis 500nm und/oder zwischen 580 bis 730nm zu emittieren.

Die Erfindung betrifft auch eine Agri-Photovoltaikanlage (10) mit einer Ständeranordnung (11) und zahlreichen durch diese getragenen Photovoltaikmodulen, die in der beschriebenen Weise ausgeführt sind.

## Beschreibung

Die vorliegende Erfindung betrifft ein Photovoltaikmodul mit mehreren bei Lichteinfall elektrische Energie erzeugenden Solarzellen, die zwischen transparenten Trägerplatten angeordnet sind, wobei zwischen jeweils benachbarten Solarzellen transparente Abstandsbereiche verbleiben, in denen sich die Solarzellen nicht erstrecken. Die Erfindung betrifft außerdem eine Agri-Photovoltaik-Anlage mit mehreren derartigen Modulen.

Photovoltaikmodule (auch Solarmodule genannt) werden zur Gewinnung elektrischer Energie zunehmend an unterschiedlichen Standorten installiert. Beispielsweise werden bei sogenannten Aufdachanlagen auf Steildächern von Gebäuden die Module direkt auf die Dachhaut montiert, da der Einfallwinkel für die Sonnenstrahlung gut ist. Bei Freiflächenanlagen werden die Module auf Ständern oder ähnlichen Trägern montiert, um einen guten Einfallwinkel für die Sonnenstrahlung zu erreichen. Aufgrund wachsenden Bedarfs an erneuerbaren Energien werden unterdessen nennenswerte Flächen für den Aufbau von Solaranlagen benötigt. Dies führt bei Freiflächenanlagen zu einem Konflikt mit dem Wunsch nach landwirtschaftlicher Nutzung der Flächen bzw. der Erhaltung von Grünland zur Erfüllung ökologischer Bestrebungen.

Im Leitfaden "Agri-Photovoltaik: Chance für Landwirtschaft und Energiewende", April 2022, Fraunhofer Institut für Solare Energiesysteme ISE werden Vorschläge zur gleichzeitigen Nutzung landwirtschaftlicher Flächen für den Kulturanbau und die Stromerzeugung gemacht. Einen erfolgversprechenden Ansatz bildet dabei die die sogenannte Agri-Photovoltaik (Agri-PV). In dem Leitfaden wurde gezeigt, dass durch Agri-PV-Installationen deutliche Mehrerträge pro Flächeneinheit erzielt werden können.

Die EP 2 398 0 64 A1 beschreibt eine photovoltaische Freiflächenanlage, die eine Nutzung eines darunterliegenden Bodens ermöglicht und gleichzeitig an verschiedene Oberflächen eines Grundstücks anpassbar sowie stabil und wetterfest ist und eine schnelle und einfache Montage ermöglicht. Die photovoltaische Freiflächenanlage besitzt eine Vielzahl von Photovoltaik-Modulen, eine Vielzahl von Masten, eine Vielzahl von Längsträgern, die jeweils mindestens zwei hintereinander angeordnete Masten miteinander verbinden, und mindestens eine Traverse, die zwischen zwei einander gegenüberliegenden Längsträgern angebracht ist und mindestens einen Querträger aufweist, an dem mindestens eines der Photovoltaik-Module befestigt ist. Die Traverse wird von mindestens zwei Traversenhalterungen gehalten, die jeweils an einem der zwei einander gegenüberliegenden Längsträger befestigt sind. Jede Traversenhalterung umfasst mindestens eine Aufnahme, die jeweils um eine horizontale Achse kippbar ist, sodass eine Ausrichtung der jeweiligen horizontalen Achse in einer horizontalen Ebene einstellbar ist.

In der DE 10 2022 100 979 A1 ist ein ausrichtbares Fotovoltaikmodul mit einem mehrere Fotovoltaikzellen enthaltenden Panel sowie mindestens zwei Halterungen beschrieben. Das Panel besitzt ein Längen/Breiteverhältnis >4, wobei maximal zwei Fotovoltaikzellen in der Breitenrichtung des Panels nebeneinander und mindestens zehn Fotovoltaikzellen in der Längenrichtung des Panels aufeinanderfolgend angeordnet sind. Die Halterungen besitzen jeweils einen Kopfbereich, an welchem das Panel an seinen Längsseiten befestigt ist, und einen Fußbereich zur Montage auf einem Träger. Die Halterung ist als ein profilierter Materialstreifen gebildet, der auf der Trägerseite des Panels angebracht ist. Der Fußbereich ist so geformt, dass die Befestigung am Träger in einem veränderlichen Winkel zur Auflagefläche des Trägers erfolgen kann.

Bekannt ist auch der Einsatz von Pigmenten bzw. Leuchtstoffen zur Erhöhung der Effizienz von Solarmodulen durch Lichtmodifikation. Hierbei werden Wellenlängen, bei welcher die Effizienz der Solarzelle nicht besonders hoch ist, in Wellenlängen umgewandelt, bei denen der Energieertrag deutlich erhöht ist. So beschreibt die EP 1 562 2 06 B1 eine farbstoffsensibilisierte Solarzelle mit erweitertem Wellenlängenbereich. Sie Solarzelle besitzt eine erste Elektrode, die ein lichtdurchlässiges Material aufweist; eine poröse Schicht, die auf einer Oberfläche der ersten Elektrode gebildet ist; einen Mischfarbstoff, der in die poröse Schicht absorbiert wird, wobei der Mischfarbstoff zwei oder mehr Farbstoffe aufweist; eine zweite Elektrode, die der porösen Schicht auf der ersten Elektrode zugewandt ist; und einen zwischen der ersten und zweiten Elektrode getränkten Elektrolyten.

Die WO 2014/197 393 A1 betrifft Zusammensetzungen zur Bildung eines photostabilen Wellenlängenkonversionsmaterials, das mindestens ein Chromophor, mindestens ein optisch transparentes vernetzbares Polymer und mindestens ein Vernetzungsreagenz enthält. In einigen Ausführungsformen enthält die Zusammensetzung außerdem einen oder mehrere Haftvermittler, einen Stabilisator, einen Vernetzer und/oder ein Antioxidationsmittel. Diese Zusammensetzung kann zu einer Folie geformt werden. Die Folie eignet sich zur Verkapselung von Solarenergievorrichtungen, da sie die photoelektrische Umwandlungseffizienz dieser Vorrichtungen erhöht, indem sie Photonen von einer Wellenlänge in eine andere, wünschenswertere Wellenlänge umwandelt, die von der Solarenergievorrichtung effizienter genutzt werden kann. Gleichzeitig bietet die Folie einen stabilen Langzeit-Umweltschutz für die Solarenergievorrichtung und schützt gegen das Eindringen von Sauerstoff und Wasser sowie vor schädlichen hochenergetischen ultravioletten Photonen. Die Folie eignet sich auch als Dachmaterial für Gewächshäuser.

Die US 2010/0294366 A1 betrifft eine fluoreszierende Harzzusammensetzung und ein Solar-Batterie-Modul mit dieser Zusammensetzung. Dafür wird ein organischer Seltenerdmetallkomplex beschrieben, der Fluoreszenz mit einer Wellenlänge im Bereich von 550 bis 900 nm emittiert. Es wird ist eine fluoreszierende Harzzusammensetzung erwähnt, die ein Ethylen-Vinylacetat-Copolymer umfasst, das 0,01 bis 10 Masse-% eines organischen Seltenerdmetallkomplexes enthält. Es werden auch ein Solarbatteriemodul, das die fluoreszierende Harzzusammensetzung als Dichtungsmaterial zwischen einer Frontabdeckung und einer kristallinen Siliziumzelle verwendet, und eine Solarbatterie mit hoher Umwandlungseffizienz beschrieben.

Die WO 2022/246 835 A1 beschreibt ein reflektierendes Gitter für photovoltaische Modulfolien und ein Verfahren zu dessen Herstellung. Das Verfahren umfasst die Bereitstellung einer wässrigen Pigment-Polyolefin-Dispersion und das Aufbringen eines Gittermusters dieser Dispersion auf eine rückseitige Verkapselungsfolie. Das Verfahren umfasst weiterhin das Trocknen des Gittermusters zu einer Gitterschicht, um eine gerasterte rückseitige Verkapselungsfolie zu bilden. Das Verfahren umfasst auch das Aufbringen einer Vielzahl von photovoltaischen Zellen und eines vorderen Verkapselungsfilms auf den gerasterten hinteren Verkapselungsfilm, um einen Stapel zu bilden, und das Laminieren des Stapels, um ein reflektierendes photovoltaisches (PV) Modul zu bilden.

Trotz all dieser Vorschläge verbleibt allerdings das Problem, dass bei gesteigerter Effizienz der Solarzellen weniger für Nutzpflanzen, die unter den Modulen angebaut werden sollen, verwertbare Lichtstrahlung zur Verfügung steht, sodass die landwirtschaftlich erzielbaren Erträge bei Agri-PV-Anlagen gering sind.

Eine Aufgabe der Erfindung besteht ausgehend vom Stand der Technik darin, ein verbessertes Photovoltaikmodul bereitzustellen, welches bei optimierter Leistung zur Erzeugung elektrischer Energie gleichzeitig mehr durch Nutzpflanzen nutzbare Lichtstrahlung bereitstellt, um die unterhalb des Moduls liegenden Flächen einer verbesserten landwirtschaftlichen Nutzung zuführen zu können. Insbesondere soll eine Agri-Photovoltaikanlage bereitgestellt werden, die eine Ertragssteigerung bei Nutzpflanzen gestattet.

Die Aufgabe wird durch ein Photovoltaikmodul gemäß dem beigefügten Anspruch 1 gelöst.

Das erfindungsgemäße Photovoltaikmodul umfasst mehrere bei Lichteinfall elektrische Energie erzeugende Solarzellen. Die Solarzellen sind zwischen transparenten Trägerplatten reihen- oder matrixförmig angeordnet. Im einfachsten Fall besitzt das Solarmodul nur zwei nebeneinanderliegende Solarzellen, regelmäßig werden aber beispielsweise 4x4 Zellen matrixartig oder 8 Zellen in einer Reihe angeordnet. Zwischen jeweils benachbarten Solarzellen verbleiben transparente Abstandsbereiche, in denen sich die Solarzellen nicht erstrecken und die je nach Fertigungstechnologie einige Millimeter bis mehrere Zentimeter breit sein können. Erfindungsgemäß befinden sich mindestens in einigen, vorzugsweise in allen Abstandsbereichen anorganische Konversionsleuchtstoffe, die Strahlungsanteile aus dem natürlichen Tageslicht mit Wellenlängen im Absorptionsbereich absorbieren und dadurch zu einer Emission in einem anderen Wellenlängenbereich angeregt werden, um Wellenlängen im Emissionsbereich zu emittieren. Der Absorptionsbereich ist vorzugsweise so gewählt, dass er größtenteils Wellenlängen enthält, die von den jeweils ausgewählten Nutzpflanzen nicht oder nur schlecht für die Ausführung der Photosynthese nutzbar sind. Der Emissionsbereich enthält vor allem Strahlungswellenlängen, die von den Nutzpflanzen besonders effizient absorbiert werden und für die Ausführung der Photosynthese nutzbar sind. Tatsächlich sind die besonders für die Photosynthese nutzbaren Wellenlängen bei unterschiedlichen Pflanzen verschieden, sodass die im Photovoltaikmodul genutzten anorganische Konversionsleuchtstoffe bevorzugt an die Pflanzenarten angepasst sind, welche unterhalb der jeweiligen Photovoltaikmodule angebaut werden sollen.

Vorzugsweise befindet sich in den Abstandsbereichen zwischen den Trägerplatten ein transparentes Schichtmaterial, in welchem die anorganischen Konversionsleuchtstoffe eingebracht sind. Das transparente Schichtmaterial dient bevorzugt gleichzeitig als Binder zwischen den Trägerplatten. Alternativ können die anorganischen Konversionsleuchtstoffe aber auch in Folie eingebracht sein, welche an den Trägerplatten aufgeklebt wird, oder die anorganischen Konversionsleuchtstoffe werden direkt im Material der Trägerplatten (vorzugsweise Glas) eingebracht.

In abgewandelten Ausführungsformen besteht die untere Trägerplatte des Photovoltaikmoduls aus Kunststoff, in dem die anorganischen Konversionsleuchtstoffe eingebettet sind. Das macht die Module leichter und die gesamte Agri-Photovoltaik-Installation kostengünstiger. Beispiele für geeignete Kunststoffe sind Polykarbonat, PET oder auch rein aliphatische Polymere wie HDPE oder PP.

Durch den erfindungsgemäßen Einsatz von lichtumwandelnden anorganischen Konversionsleuchtstoffen kann eine wesentliche Effizienzsteigerung bei den genannten Agri-Photovoltaik-Anwendungen erreicht werden. Die Pigmente absorbieren optische Wellenlängen, die weder zur Energiegewinnung durch die Solarzelle noch zur Photosynthese durch die unterhalb der aufgeständerten Photovoltaikmodule angebauten Kulturpflanzen effizient nutzbar sind. Die von den anorganischen Konversionsleuchtstoffen aufgenommene Strahlungsenergie wird umgewandelt und führt zu einer zusätzlichen Emission in Wellenlängenbereichen, die die Photorezeptoren der Pflanze gut ansprechen. Das führt zu einer verstärkten Biomasseproduktion neben der unverändert hohen Erzeugung von Photovoltaik-Strom durch die Solarzelle. Bei wertvollen Feldfrüchten ist selbst ein landwirtschaftlicher Mehrertrag von nur wenigen Prozent aufgrund der zu erwartenden Großflächigkeit der Agri-Photovoltaikanlagen von wirtschaftlichem Interesse.

Ein weiterer Vorteil ist darin zu sehen, dass die erfindungsgemäß gewählten anorganischen Konversionsleuchtstoffe für die Pflanze schädliche Strahlung absorbieren und dadurch die Pflanze vor Schäden schützen, beispielsweise dem Verbrennen aufgrund hoher Strahlungsanteile, die von den pflanzlichen Photorezeptoren nicht für die Photosynthese nutzbar sind.

Die im erfindungsgemäßen Photovoltaikmodul genutzten anorganischen Konversionsleuchtstoffe sind bevorzugt anorganische Materialien. In bevorzugten Ausführungsformen können außerdem Halbleiter-Nanopartikel eingebettet sein. Derartige anorganische Materialien enthalten ein oder mehrere Emissionszentren, eingebettet in Kristallstrukturen. Derartige Emissionszentren finden sich in der Reihe der Seltenen Erden aber auch bei Metallen, wie Fe, Cr, Co, Ni, Mn, Cu, Ag, Au oder auch Zn. Auch Hauptgruppenelemente, wie zum Beispiel Sb, Sn, Pb und Bi sind mögliche Emissionszentren. Beispiele für erfindungsgemäße nutzbare Kristallsysteme sind Phosphate, Aluminate, Granate, Silikate, Orthosilikate, Alumosilikate, Sulfide, Oxisulfide, Sulfate, Fluoride, Oxifluoride, Titanate, Molybdate, Vanadate, Antimonate, Indate, Nitride und Oxynitride, Nitridosilikate, Nitridoaluminate oder auch Oxonitridoaluminate. Es können aber auch komplexere Kristallsysteme genutzt werden, um die Emissionszentren einzubetten. Die vorgenannten anorganischen Materialien zeichnen sich durch eine hohe Transparenz für die emittierte Nutzstrahlung aus, absorbieren aber in spezifischen elektromagnetischen Absorptionsbereichen, vorzugsweise UV-Strahlung, violettes Licht, grünes Licht oder auch NIR-Strahlung. Für Pflanzen interessante und durch die anorganischen Materialien erzeugte Emissionen finden sich insbesondere im Emissionsbereich zwischen 430 bis 500nm und 580 bis 730nm.

Photorezeptoren sind lichtempfindliche Proteine mit unterschiedlichen Farben, die in Pflanzen, Algen, Cyanobakterien und Pilzen auftreten. Im Zusammenhang mit der hier beschriebenen Erfindung sind Phytochrome und Cryptochrome von besonderer Bedeutung. Phytochrome messen das Verhältnis aus kurzwelligem rotem Licht (<700 nm) und langwelligem rotem Licht (>700 nm). Sie steuern dadurch Wachstums- und Entwicklungsvorgänge von Pflanzen, z.B. die Samenkeimung oder die Blüteninduktion. Cryptochrome sind für die Wahrnehmung von blauem Licht zuständig und sind beteiligt an der Aufrechterhaltung des circadianen Rhythmus. Weitere pflanzliche Photorezeptoren sind die Phototropine, die ihr Absorptionsmaximum ebenfalls im kurzwelligen optischen Spektrum haben.

Als Materialien, die in das transparente Schichtmaterial eingebettet werden, eignen sich verschiedene anorganische Konversionsleuchtstoffe, welche die zuvor genannten Eigenschaften erfüllen. Bevorzugt werden folgende Konversionsleuchtstoffe einzeln oder in Kombination miteinander eingesetzt:
als Blaukomponente
   CaF₂:Eu, BaMgAl₁₀O₁₇:Eu, (Ba,Sr,Ca)₃MgSi₂O₈:Eu, Sr₂P₂O₇:Sn, YF₃:Mn, (Ba, Sr, Ca)₅(PO₄)₃Cl:Eu, BaAl₂O₄:Eu;
und als Rotkomponente
   (Sr,Ca)₂SiO₄:Eu, SrS:Eu, YVO₄:Eu, K₂SiF₆:Mn, YPO₄:Eu, CaTiO₃:Eu, Gd₂O₂S:Eu, Y₃Al₅O₁₂:Mn, CaS:Eu, Mg₂TiO₄:Mn, (Sr,Ca)AlSiN₃:Eu, Y₃Al₅O₁₂:Cr, (Ba,Sr,Ca)₃MgSi₂O₈:Eu,Mn, Al₂O₃:Cr.

Als besonderer Vorteil der genannten Konversionsleuchtstoffe erweist sich auch deren hohe Photostabilität über lange Zeiträume. Die gewünschte Strahlungskonversion bleibt lange erhalten und die stabilisierende Wirkung auf das transparente Schichtmaterial ebenso.

Neben den zuvor genannten, besonders bevorzugten Konversionsleuchtstoffen gibt es weitere geeignete anorganische Konversionsleuchtstoffe, die zur Realisierung der Erfindung eingesetzt werden können. Die zuvor genannte Liste soll daher nicht als vollständig angesehen werden.

Gemäß einer abgewandelten Ausführungsform können auch Halbleiter-Nanopartikel in das transparente Schichtmaterial eingebracht werden. Solche Halbleiter-Nanopartikel ermöglichen es ebenfalls, kurzwelliges Licht in die genannten bevorzugten Emissionsbereiche zu konvertieren. Derartige Halbleiter-Nanopartikel werden auch als Quantumdots bezeichnet. Geeignete Halbleitermaterialien aus Gruppe II-VI-Halbleitern, Gruppe III-V-Halbleitern, Gruppe IV-VI-Halbleitern, Gruppe I-III-VI₂-Halbleitern sowie aus Legierungen und/oder Kombinationen dieser Halbleiter. Die Halbleitermaterialien können wahlweise mit einem oder mehreren Übergangsmetallen dotiert sein.

Ein wichtiger Vorteil der Erfindung besteht darin, dass vor allem in der Zeit am frühen Nachmittag, also bei absinkendem Sonnenstand (in Regionen Mitteleuropas), die dann verstärkt auftretende Beschattung bzw. die Reduktion der Strahlungsintensität und der erhöhte Anteil an kurzwelliger Strahlung nun durch die Konversionsleuchtstoffe des Photovoltaikmoduls in langwelliges Licht umgewandelt werden. Die Photorezeptoren der unter den Photovoltaikmodulen angebauten Kulturpflanzen werden dadurch verstärkt angesprochen und das Wachstum wird beschleunigt. Ein weiterer positiver Effekt der Erfindung besteht darin, dass Verdunstungen vom Boden durch die geringere Aufheizung reduziert und die Pflanzen somit optimaler mit Feuchtigkeit versorgt werden.

Weiterhin sorgen die Konversionsleuchtstoffe in den Photovoltaikmodulen durch die Absorption energiereicher Strahlung für eine deutlich langsamere Alterung, was sich durch weniger Vergilbung des Schichtmaterials zeigt. Dies gilt vor allem für die auf organischer Basis bestehenden Bindemittel des Schichtmaterials, die langsamer durch Photodegradation zersetzt werden. Schließlich bewirken die feinkörnigen Konversionsleuchtstoffe eine Lichtstreuung, sodass eine gleichmäßigere Ausleuchtung der Flächen unter den Photovoltaikmodulen mit diffuser Strahlung resultiert.

Gemäß einer bevorzugten Ausführungsform besitzt das Photovoltaikmodul eine schmale, langgestreckte Form und ist bevorzugt als rahmenloses Modul ausgelegt. Dies ermöglicht es, das Photovoltaikmodul durch Drehung um seine Längsachse auszurichten, ohne dass benachbarte Module einen unerwünschten Schatten aufeinander werfen. Weiterhin sind schmale Module weniger windanfällig, was die Kosten großflächiger Installationen durch eine günstige Aufständerung gering hält. Regen und Verunreinigungen können an kleinen, rahmenlosen Modulen besser ablaufen, ohne auf dem Boden unter den Photovoltaikmodulen Ausspülungen mit verstärkten Erosionseffekten zu verursachen. Somit kann die duale Nutzung von Agrarflächen hinsichtlich Feldfrucht- und Stromertrag nachhaltig erhöht werden.

Gemäß bevorzugter Ausführungsformen umfassen die Photovoltaikmodule eine oder zwei Reihen von mono- oder multikristallinen Solarzellen, die nebeneinander angeordnet sind und je nach Modullänge eine Vielzahl an Zellen beinhalten. Besonders bevorzugt sind die Photovoltaikmodule als bifaciale Glas-Glas-Module ausgebildet, insbesondere mit 18-25 cm Breite und 160-180 cm Länge. Beispielsweise sind in diesen Modulen bis zu 20 Halbzellen oder 40 Viertelzellen in Reihe geschaltet, um eine möglichst hohe Spannung zu erhalten.

Gemäß alternativer Ausführungsformen können die Photovoltaik-module andere Solarzellen enthalten, vorzugsweise ausgewählt aus der folgenden Liste:
- Silizium-basierte Solarzellen;
- Copper-Indium-Gallium-Diselenide (CIGS/CIS);
- III/V Solarzellen, wie Gallium-Arsenide (GaAs) Solarzellen oder multi-junction Solarzellen, basierend auf Germanium/Indium-(Aluminium)-Gallium-Arsenide oder Phosphide (In(Al)GaAs/P);
- Dye sensitized Solarzellen (DSSC);
- Organische Solarzellen (OSC);
- Perovskite Solarzellen (PSC);
- Quantum-dot-Solarzellen (QSC);
- II/VI Solarzellen wie Zinkselenide (ZnSe) oder Eisensulfide (FeS)
- Tandem-Solarzellen;

Die erfindungsgemäße Agri-Photovoltaikanlage zeichnet sich dadurch aus, dass sie mehrere Photovoltaikmodule der zuvor beschriebenen Art besitzt, welche auf einer passenden Ständeranordnung montiert sind.

Bevorzugt sind die einzelnen Photovoltaikmodule mit modularen Halterungssystemen an der Ständeranordnung befestigt. Dies führt zu minimalem Schattenwurf. Vorzugsweise kann die Ausrichtung der Photovoltaikmodule durch schwenkbare Lagerung individuell angepasst werden. Dies führt dazu, dass z.B. auf einer nach Süden ausgerichteten Fläche die Photovoltaikmodule verkippt werden können, um eine Ausrichtung nach Osten, Südosten, Süden, Südwesten oder Westen für jeweils einzelne Module zu ermöglichen. Das Gesamtsystem kann dadurch an die jeweils abführbare Stromnutzlast angepasst werden. Insbesondere können einzelne Module aus dem direkten Lichteinfall heraus geschwenkt werden, wenn die Abnahme der elektrischen Leistung nicht gewährleistet ist, sodass in diesen Fällen eine verbesserte Lichteinstrahlung auf die Nutzpflanzen erfolgt.

Weiterhin kann die durch schwenkbare Photovoltaikmodule erreichte Beschattung an die Bedürfnisse der Kulturpflanzen angepasst werden. Gerade in den Vormittagsstunden sprechen die Pflanzen sehr gut auf Sonnenlicht an, während eine zu starke Sonneneinstrahlung am frühen Nachmittag oft zu "Verbrennungen" führen kann.

Die Ständeranordnung der Agri-Photovoltaikanlage ist bevorzugt als eine Metallkonstruktion ausgelegt und derart über Nutzpflanzen montiert, dass sie durch die anpassbare Ausrichtung der Photovoltaikmodule den Pflanzen Schutz vor zu starker Sonneneinstrahlung, Hagel, starkem Regen und zu starker Verdunstung von Wasser aus dem Boden bietet. Bevorzugt sind die Photovoltaikmodule derart an der Ständeranordnung angebracht, dass die Kulturpflanzen keinem Kernschatten ausgesetzt sind.

Eine alternative Anwendung der beschriebenen Photovoltaik-module ist die Positionierung über Wasserreservoiren, um die Verdunstung und zu starke Erwärmung durch zu intensive Sonneneinstrahlung zu reduzieren.

Eine alternative Nutzung der erfindungsgemäßen Photovoltaikmodule ist an Pergolen oder gleichartigen Bauten möglich. Dazu werden schmale bifaciale Photovoltaikmodule als Überdachungselemente an Pergolen verwendet. Die erfindungsgemäßen Module bieten zusammen mit einer flexiblen Halterung Vorteile, besonders in der Nachrüstung von Pergolen. Da Pergolen oftmals bepflanzt sind, kann hier ebenfalls ein positiver Effekt durch die Lichtmodifikation erreicht werden, indem die Pflanze zum Beispiel mehr Blüten ausbildet. Sehr gute Ergebnisse werden ebenfalls für Weinpflanzen erzielt.

Weitere Vorteile und Einzelheiten der Erfindung ergeben sich aus der nachfolgenden Beschreibung bevorzugter Ausführungsformen, unter Bezugnahme auf die Zeichnung. Es zeigen:
- Fig. 1: vereinfachte Draufsichten auf zwei Ausführungsformen eines erfindungsgemäßen Photovoltaikmoduls;
- Fig. 2: eine schematische Querschnittsansicht des Photovoltaikmoduls;
- Fig. 3: eine schematische Ansicht einer Agri-Photovoltaikanlage;
- Fig. 4: ein Diagramm mit Absorptionskurven von pflanzlichem Chlorophyll.

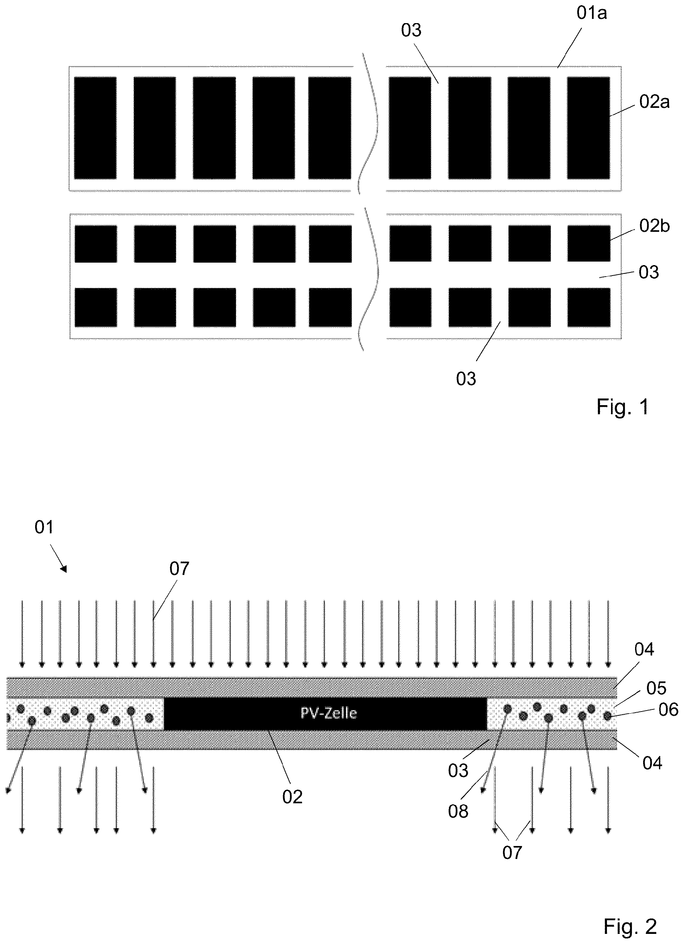

Fig. 1 zeigt die Draufsicht auf zwei bevorzugte Ausführungsformen eines erfindungsgemäßen Photovoltaikmoduls 01, jeweils mit mehreren Solarzellen 02. Die obere Abbildung zeigt ein Photovoltaikmodul 01a, bei welchem zahlreiche Solarhalbzellen 02a reihenförmig nebeneinander angeordnet sind. Die in der unteren Abbildung gezeigte Ausführungsform verwendet stattdessen zahlreiche Solarviertelzellen 02b, die matrixförmig, insbesondere in zwei Reihen angeordnet sind. Das Photovoltaikmodul 01 besitzt aufgrund der Anordnung der Solarzellen in einer oder maximal zwei Reihen eine schmale, langgestreckte Form. Zwischen den Solarzellen 02 verbleiben Abstandsbereiche 03, in denen sich keine Solarzellen erstrecken. In den Abstandsbereichen 03 sind anorganische Konversionsleuchtstoffe angeordnet, die Strahlung in einem vorbestimmten Absorptionsbereich absorbieren, um dadurch angeregte Strahlung in einem Emissionsbereich zu emittieren. Der Emissionsbereich liegt im Wellenlängenbereich zwischen 430 bis 500nm und/oder 580 bis 730nm.

Fig. 2 zeigt eine schematische Querschnittsansicht des Photovoltaikmoduls 01. Es ist ersichtlich, dass die Solarzelle 02 zwischen zwei transparenten Trägerplatten 04 angeordnet ist und jeweils an ihren Rändern von Schichtmaterial 05 eingefasst ist, welches als Binder wirkt und die Trägerplatten 04 zusammenhält. Bevorzugt handelt es sich um bifaciale Solarzellen, die auf beiden Seiten einfallendes Licht absorbieren und dadurch zur Stromerzeugung angeregt werden. In das Schichtmaterial 05 sind zahlreiche, kleinste anorganische Konversionsleuchtstoffpartikel 06 eingebracht, die möglichst gleichmäßig im Schichtmaterial 05 verteilt sind. Während des Betriebs fällt Sonnenlicht 07 auf das Photovoltaikmodul 01, durchdringt im Wesentlichen ungehindert die obere Trägerplatte 04 und wird von der Solarzelle 02 weitgehend absorbiert, um elektrische Energie zu gewinnen. In den Abstandsbereichen 03 tritt das Sonnenlicht 07 teilweise durch das Schichtmaterial 05 hindurch und verlässt das Modul an der unteren Trägerplatte 04 mit unveränderter Wellenlänge als transmittiertes Sonnenlicht 07a. Ein anderer Teil des einfallenden Sonnenlichts 07 trifft auf die Konversionsleuchtstoffpartikel 06 auf. Die Konversionsleuchtstoffpartikel 06 wandeln Strahlung im Absorptionsbereich um und emittieren in einen anderen Wellenlängenbereich, nämlich dem Emissionsbereich.

Emittierte Strahlung 08 verlässt das Photovoltaikmodul u.a. über die untere Trägerplatte 04 in Richtung zu Nutzpflanzen (nicht gezeigt), die unter dem Photovoltaikmodul angebaut werden.

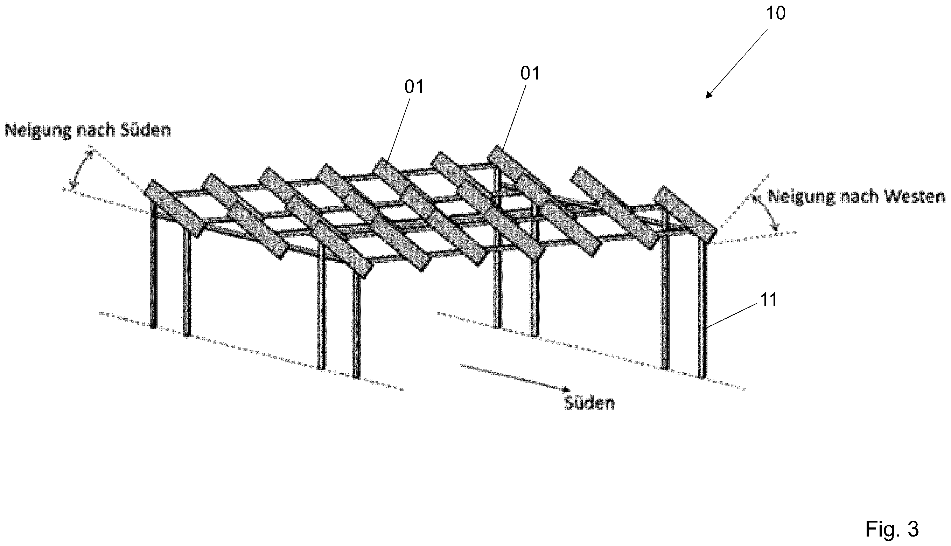

Fig. 3 zeigt eine schematische Ansicht einer Agri-Photovoltaikanlage 10. Zahlreiche Photovoltaikmodule 01 sind auf einer Ständeranordnung 11 befestigt, wobei jedes einzelne Photovoltaikmodul um seine Längsachse schwenkbar ist, um die Neigung nach Osten bzw. Westen einzustellen. Gleichzeitig kann hierdurch die resultierende Beschattung unterhalb der Photovoltaikmodule an die jeweilige dort gepflanzte Kulturpflanze und den Standort angepasst werden. Die Neigung der Photovoltaikmodule in Richtung Süden ist festgelegt durch die Ständeranordnung 11.

Die Ständeranordnung 11 ist bevorzugt als Metallkonstruktion ausgebildet. Die Photovoltaikmodule sind dadurch so über Nutzpflanzen angeordnet, dass die Anlage den Pflanzen Schutz vor starker Sonneneinstrahlung, Hagel, starkem Regen und zu starker Verdunstung von Wasser aus dem Boden bietet. Die einzelnen Photovoltaikmodule können dazu in verschiedene Richtungen ausgerichtet werden und sind vorzugsweise motorisch verstellbar. Ein großer Vorteil der Verwendung beweglicher, erfindungsgemäßer Photovoltaikmodule gegenüber Standardmodulen ist eine homogenere Lichtverteilung und Lichtmodifikation durch die Pigmente.

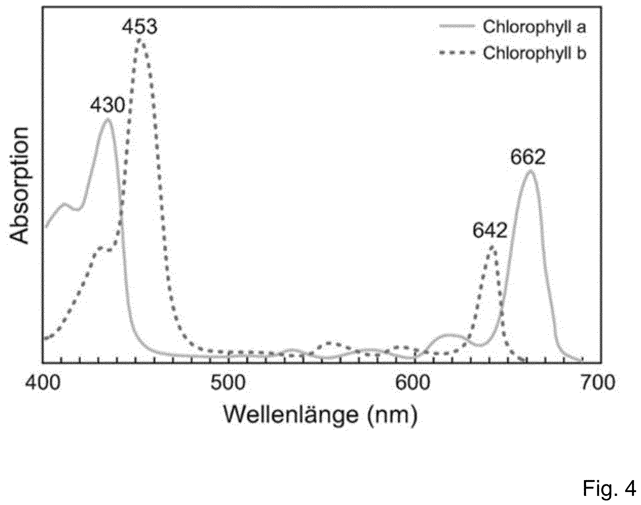

Fig. 4 zeigt ein Diagramm mit Absorptionskurven von pflanzlichem Chlorophyll. Dargestellt sind zwei Absorptionskurven des pflanzlichen Chlorophyll a und Chlorophyll b, die in unterschiedlichen Pflanzen auftreten. In den Wellenlängenbereichen mit hoher Absorption führt eine

Verstärkung der Strahlungsintensität zu einer größeren Photosyntheseleistung. Die in den Photovoltaikmodulen genutzten anorganischen Konversionsleuchtstoffe konvertieren Strahlungsanteile des Sonnenlichts genau in diese Bereiche.

### Bezugszeichen

- 01: Photovoltaikmodul
- 02: Solarzellen
- 03: Abstandsbereiche
- 04: Trägerplatten
- 05: Schichtmaterial / Binder
- 06: Konversionsleuchtstoff
- 07: Sonnenlicht
- 08: emittierte Strahlung im Emissionsbereich
- 09: -
- 10: Agri-Photovoltaikanlage
- 11: Ständeranordnung

## Patentansprüche

1. Photovoltaikmodul (01) mit mehreren bei Lichteinfall elektrische Energie erzeugenden Solarzellen (02), die zwischen transparenten Trägerplatten (04) reihen- oder matrixförmig angeordnet sind, wobei zwischen jeweils benachbarten Solarzellen (02) transparente Abstandsbereiche (03) verbleiben, in denen sich die Solarzellen nicht erstrecken, wobei mindestens in einigen der Abstandsbereiche (03) in einem transparenten Schichtmaterial (05) anorganische Konversionsleuchtstoffe (06) eingebracht sind, die UV-Strahlung, violette Strahlung, grüne Strahlung und/oder NIR-Strahlung absorbieren, um dadurch angeregt Strahlung in mindestens einem Emissionsbereich zwischen 430 bis 500nm und/oder zwischen 580 bis 730nm zu emittieren, wobei die anorganischen Konversionsleuchtstoffe (06) ausgewählt sind aus der folgenden Liste:
CaF₂:Eu, BaMgAl₁₀O₁₇:Eu, (Ba,Sr,Ca)₃MgSi₂O₈:Eu, Sr₂P₂O₇:Sn, YF₃:Mn, (Ba,Sr,Ca)₅(PO₄)₃Cl:Eu, BaAl₂O₄:Eu, (Sr,Ca)₂SiO₄:Eu, SrS:Eu, YVO₄:Eu, K₂SiF₆:Mn, YPO₄:Eu, CaTiO₃:Eu, Gd₂O₂S:Eu, Y₃Al₅O₁₂:Mn, CaS:Eu, Mg₂TiO₄:Mn, (Sr,Ca)AlSiN₃:Eu, Y₃Al₅O₁₂:Cr, (Ba,Sr,Ca)₃MgSi₂O₈:Eu, Mn, Al₂O₃:Cr.

2. Photovoltaikmodul (01) nach Anspruch 1, **dadurch gekennzeichnet, dass** in den transparenten Abstandsbereichen (03) weiterhin Halbleiter-Nanopartikel vorgesehen sind, wobei die Halbleitermaterialien ausgewählt sind aus der folgenden Liste:
Gruppe II-VI-Halbleiter, Gruppe III-V-Halbleiter,
Gruppe IV-VI-Halbleiter, Gruppe I-III-VI₂- Halbleiter.

3. Photovoltaikmodul (01) nach Anspruch 2, **dadurch gekennzeichnet, dass** die Halbleitermaterialien mit einem oder mehreren Übergangsmetallen dotiert sind.

4. Photovoltaikmodul (01) nach einem der Ansprüche 1 bis 3, **dadurch gekennzeichnet, dass** die Solarzellen (02) in ein oder zwei Reihen nebeneinander angeordnet sind.

5. Photovoltaikmodul (01) nach einem der Ansprüche 1 bis 4, **dadurch gekennzeichnet, dass** die Solarzellen (02) mono- oder multikristalline Solarzellen sind.

6. Photovoltaikmodul (01) nach einem der Ansprüche 1 bis 5, **dadurch gekennzeichnet, dass** es als bifaciales Glas-Glas-Modul ausgebildet ist.

7. Agri-Photovoltaikanlage (10) umfassend eine Ständeranordnung (11) und zahlreiche durch diese getragene Photovoltaikmodule, wobei die Ständeranordnung unter den Photovoltaikmodulen Raum zum Anbau von Nutzpflanzen belässt, **dadurch gekennzeichnet, dass** die Photovoltaikmodule (01) gemäß einem der Ansprüche 1 bis 6 ausgeführt sind.

8. Agri-Photovoltaikanlage (10) nach Anspruch 7, **dadurch gekennzeichnet, dass** die Photovoltaikmodule (01) einzeln schwenkbar an der Ständeranordnung (11) befestigt sind.
